# EUROPEAN PATENT SPECIFICATION

(11) **EP 0 300 801 B1**
(45) Date of publication and mention of the grant of the patent: **22.02.1995**
(21) Application number: 88306724.1
(22) Date of filing: 21.07.1988
(51) Int. Cl.: H03D 3/00, H04N 9/79

(54) **Frequency demodulation apparatus**
Frequenzdemodulationsgerät
Appareil de démodulation de fréquence

(30) Priority: 21.07.1987 JP 181526/87; 21.07.1987 JP 181529/87; 26.08.1987 JP 212017/87
(43) Date of publication of application: 25.01.1989
(73) Proprietor: MATSUSHITA ELECTRIC INDUSTRIAL CO., LTD., Kadoma-shi, Osaka-fu, 571 (JP)
(72) Inventor: Honjo, Masahiro, Neyagawa-shi Osaka-fu, 572 (JP)
(74) Representative: Crawford, Andrew Birkby

(56) References cited:
- GB-A- 2 176 367
- US-A- 4 052 740
- US-A- 4 223 282
- US-A- 4 561 113

## Description

This invention relates to a frequency demodulation circuit for demodulating a frequency modulated (FM) signal.

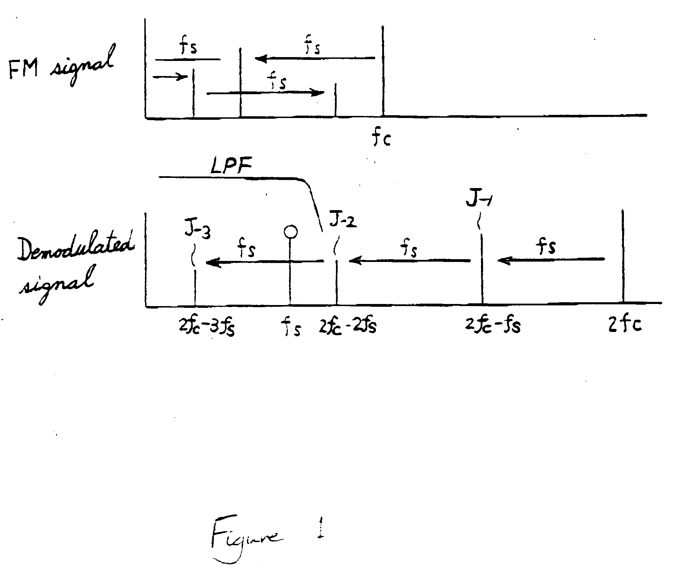

In video tape recorders (VTRs), a FM signal reproduced from a magnetic tape is demodulated by a pulse counting type frequency demodulator which detects zero-crossing points of the FM signal. The demodulated signal obtained by such frequency demodulator contain the lower sideband components of the FM signal. Among the lower sideband components, components appearing in the base band badly affect the desired signal to cause deterioration of signal quality. Such undesired components are called "moire" components. As an example, Fig.1 shows a spectrum diagram of a FM signal obtained by modulating a carrier frequency f_{c} with a signal frequency fₛ and a spectrum diagram of a demodulated signal obtained by demodulating such FM signal by a double-multiplier pulse counting type demodulator. The lower sideband components J₋₁, J₋₂, J₋₃..., J₋ₙ appearing in the demodulated signal are expressed as:
J₋₁ = 2f_{c} - fₛ, J₋₂ = 2f_{c} - 2fₛ, J₋₃ = 2f_{c} - 3fₛ, ..., J₋ₙ = 2f_{c} - nfₛ

The signal fs in the base band is obtained by passing the demodulated signal through a low-pass filter (LPF). However, there exist some lower sideband components in the base band as undesired moire components, i.e., the moire components, which degrade the quality of the obtained desired signal. In the case of Fig. 1, the third-order lower sideband components J₋₃ becomes the undesired moire component.

To reduce such undesired moire effect, the carrier frequency is generally selected to be more than 1.5 times the maximum frequency of the modulation signal. The moire effect can be reduced more by using higher carrier frequency. However, the higher carrier frequency necessarily results in lower signal to noise ratio (C/N). the carrier frequency cannot be made high enough to reduce the moire effect adequately.

United States patent US-A-4,561,113 discloses a distortion canceller which removes distortion of a demodulated signal in an FM receiver by producing the n-th power of the demodulated signal and differentiating it to derive an n-th order distortion signal. The derived n-th order distortion signal is adjusted in its amplitude level and then combined with the demodulated FM signal in such a way that the n-th order distortion signal can be cancelled from the demodulated signal. This apparatus is not applicable to the removal of moire interference.

United States patent US-A-4,052,740 discloses an apparatus for suppressing spurious interference components that arise in video recording apparatus of the type which utilizes frequency modulation of the carrier signal with a video signal. The unwanted interference signal component is suppressed by generating the second harmonic of a fundamental signal in the video information modulating signal and adding the second harmonic to the fundamental modulating signal at a predetermined phase and amplitude prior to it being modulated upon the carrier signal, the phase being that which heightens the upward deviating peaks and flattens the lower peaks of the fundamental modulating signal, and the amplitude being that which minimizes the interference component. It is possible to reduce the level of the unwanted signal substantially to zero. This apparatus is intended to suppress moire interference, but only that due to harmonics of the main signal.

In the home VTRs, the colour-under system is used which converts the frequency of the chrominance signal of the video signal into a lower frequency and mixes the low-converted chrominance signal with the frequency-modulated luminance signal for recording.

Supposing that the carrier frequency is designated as f_{c} and the down-converted chrominance signal frequency as F_{L}, a cross-modulation component is generated at the frequency of f_{c}-2f_{L} during playback due to the frequency characteristic of the electromagnetic conversion system, and a cross-modulation moire component of 2f_{L} is generated in the reproduced luminance signal after demodulation, causing deterioration of reproduced picture quality.

Conventionally, recording current of the chrominance signal is restricted to a low level to reduce the level of the cross modulation moire component below the allowable limit, but this causes deterioration of S/N of the chrominance signal.

Embodiments of the present invention provide a frequency demodulation circuit which is capable of cancelling moire components generated from the lower sideband components of a FM signal.

Embodiments of the present invention also provide a frequency demodulation circuit which is capable of cancelling an undesired cross-modulation moire component generated from a cross=modulation signal contained in a FM signal.

According to the present invention there is provided a frequency demodulation apparatus comprising frequency demodulating means for demodulating a frequency modulated signal which has a carrier frequency f_{c} and contains a low-frequency signal having a frequency f_{L} and a cross-modulation signal component expressed as f_{c} - 2f_{L} to obtain a demodulated signal which contains a frequency component 2f_{L} as an undesired cross-modulation moire component:
characterized by further comprising:
moire component generating means for extracting a low-frequency component f_{L} from said frequency-modulated signal and generating a 2f_{L} component as a moire component corresponding to said undesired cross-modulation moire component from the extracted low-frequency signal; and
subtracting means for subtracting said moire component generated by said moire component generating means from said demodulated signal thereby to obtain a demodulated signal from which said undesired cross-modulation moire component is eliminated.

There is also provided a signal recording and reproducing apparatus comprising:
means for extracting a first signal from an input signal and for frequency-modulating a carrier frequency f_{c} with the first signal to obtain a frequency-modulated signal;
means for extracting a second signal from the input signal and generating from the second signal a low-frequency signal having a frequency f_{L};
means for adding the frequency-modulated signal and the low frequency signal to obtain a recording signal;
recording and reproducing means for recording the recording signal on a recording medium and for reproducing the recorded signal from the recording medium to obtain a signal containing a reproduced low-frequency signal having the frequency f_{L} and a reproduced frequency-modulated signal which contains a cross-modulation component f_{c} - 2f_{L};
means for extracting the reproduced frequency-modulated signal from the signal reproduced by the recording and reproducing means and the demodulating the extracted signal to obtain reproduced first signal which contains a component 2f_{L} as an undesired cross-modulation moire component;
means for generating a reproduced second signal from the reproduced low-frequency signal; and
means for adding the reproduced first and second signals to obtain a reproduced signal,
characterized by further comprising:
moire component generating means for extracting a low-frequency component f_{L} from the signal reproduced by the recording and reproducing means and for generating a moire component 2f_{L} corresponding to said undesired cross-modulation moire component; and
subtracting means for subtracting said moire component generated by said moire component generating means from either said reproduced first signal or said reproduced signal thereby to obtain reproduced signal from which said undesired cross-modulation moire component is eliminated.

Generally, a FM signal obtained by modulating a carrier frequency f_{c} with a signal frequency fₛ contains a nth-order lower sideband component fₙ = f_{c} - nfₛ, where n is a natural number. A demodulated signal obtained by demodulating such FM signal by a m-times-multiplier pulse counting demodulator contains a m-multiplied carrier frequency mf_{c}, where m is a natural number, the signal frequency fs and a nth-order lower sideband component j₋ₙ - mf_{c} - nfₛ. This means that the nth-order lower sideband component J₋ₙ of the demodulated signal can be calculated as J₋ₙ = mf_{c} - nfₛ by using the m-multiplied carrier frequency mf_{c} and the signal frequency fₛ which can be obtained from the demodulated signal.

Alternatively, since the signal frequency fₛ is expressed as fₛ = f_{c} - fₙ, the component J₋ₙ can be expressed as J₋ₙ - mf_{c} - n(f_{c}-fₙ) = nfₙ - (n-m)f_{c}. This means that the nth-order lower sideband component J₋ₙ of the demodulated signal can be calculated as J₋ₙ - nfₙ - (n-m)f_{c} by using the carrier frequency f_{c} and the nth-order lower sideband component fₙ of the FM signal.

Therefore, for cancelling an nth-order lower sideband component J₋ₙ of the demodulated signal as an undesired moire component, the moire component generator may generate a component of mf_{c} - nfₛ from the demodulated signal or a component of nfₙ - (n-m)f_{c} from the input FM signal.

When a low frequency signal f_{L} is mixed into the FM signal due to crosstalk, the cross-modulation signal appears at f_{c} - 2f_{L} in the FM signal. When such FM signal is demodulated the cross-modulation signal appears at 2f_{L} in the demodulated signal as a cross-modulation moire component. To cancel such cross-modulation more component, the moire component, the moire component generator may generate the 2f_{L} frequency component from the input FM signal.

The above and other advantages and features of the invention will be more apparent from the following detailed description of preferred embodiments taken in connection with the accompanying drawings in which:
Figure 1 is a frequency spectrum diagram of a conventional example;
Figure 2 is a block diagram of a frequency demodulation apparatus according to the present invention;
Figure 3 is a block diagram of a further embodiment of a frequency demodulation apparatus according to the present invention; and
Figure 4 shows a frequency spectrum for explaining the principle of the Figs. 2 and 3 embodiments.

A frequency demodulation apparatus for cancelling cross-modulation moire according to the present invention will be described.

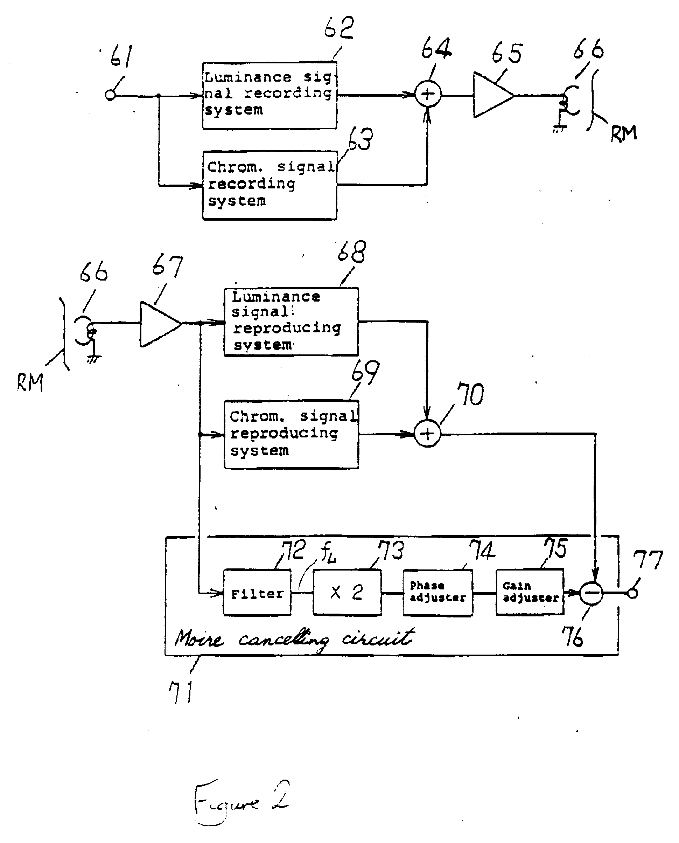

Fig. 2 is a block diagram of a preferred embodiment of the present invention which is a colour-under magnetic recording and reproducing system of a video signal. A video signal inputted via a terminal 61 is fed to both a luminance signal recording system 62 and a chrominance signal recording system 63. The luminance signal recording system 62 extracts a luminance signal from the video signal and frequency-modulates the luminance signal to obtain a FM luminance signal in the known manner. The chrominance signal recording system 63 extracts a chrominance signal from the video signal and converts the frequency of the chrominance signal to a low frequency to obtain a down-converted chrominance signal in the known manner. An adder 64 adds the FM luminance and down-converted chrominance signals to obtain a recordable video signal. This recordable video signal is amplified by an amplifier 65 and recorded by a magnetic head 66 on a magnetic recording medium RM such as a magnetic tape. The recorded video signal is reproduced by the head 66, amplified by an amplifier 67 and fed to a luminance signal reproducing system 68, a chrominance signal reproducing system 69 and a moire cancelling circuit 71. The luminance signal reproducing system 68 extracts the FM luminance signal from the reproduced video signal and demodulates the FM luminance signal to obtain a reproduced luminance signal. The chrominance signal reproducing system 69 extracts the down-converted chrominance signal from the reproduced video signal and converts the frequency of the down-converted chrominance signal to the normal high frequency to obtain a reproduced chrominance signal. An adder 70 adds the reproduced luminance and chrominance signals to obtain a reproduced composite video signal, which usually contains, as an undesired cross-modulation moire component, the component of 2f_{L}, where f_{L} is the frequency of the down-converted chrominance signal. This cross-modulation moire is generated in the luminance signal reproducing system 68.

That is, the down-converted chrominance signal f_{L} is mixed, as a cross-modulation component, into the FM luminance signal when the video signal is reproduced from the recording medium due to the frequency characteristics of the electromagnetic conversion system comprised by the recording medium RM and the magnetic head 66. This cross-modulation component becomes the cross-modulation moire component when the FM luminance signal is demodulated.

The moire cancelling circuit 71 cancels the cross-modulation moire 2f_{L}. The reproduced signal from the amplifier 67 is inputted to a filter 72 which separates the down-converted chrominance signal f_{L}. Either a low-pass filter or a band-pass filter may be used for the filter 72. The output of the filter 72 is sent to a double-multiplier (x2) 73. The double-multiplier 73 doubles the frequency f_{L} to obtain the 2f_{L} component. The 2f_{L} component has its phase and gain adjusted by a phase adjuster 74 and a gain adjuster 75, and then is sent to a subtractor 76. The subtractor subtracts the 2f_{L} component from the reproduced composite video signal outputted from the adder 70 thereby to obtain a video signal from which the cross-modulation moire 2f_{L} is eliminated and which is outputted from an output terminal 77.

In this embodiment, the subtractor 76 may not be necessarily positioned after the adder 70, but it may be located at any place after a frequency demodulator located in the luminance signal reproducing system 68.

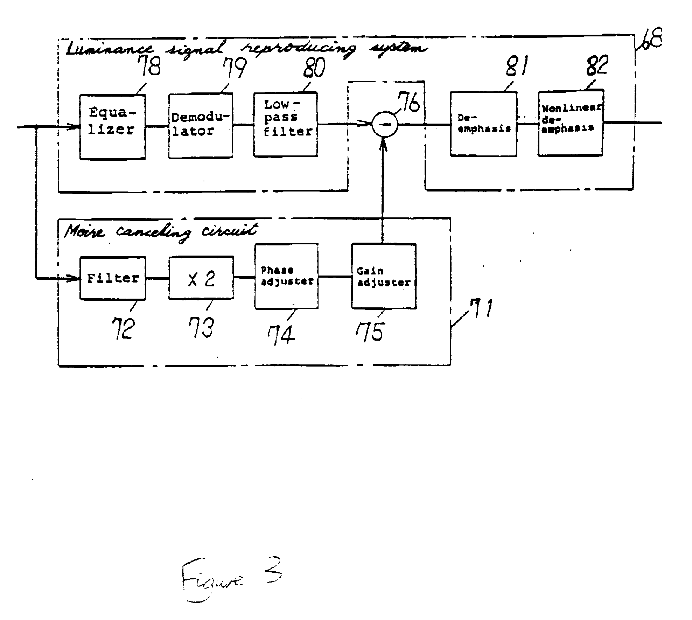

Fig. 3 shows a block diagram of another preferred embodiment of the invention which is such a modification of the Fig. 2 embodiment that the subtractor 76 is positioned in the luminance signal reproducing system 68. The luminance signal reproducing system 68 separates the FM luminance signal from the reproduced video signal, and comprises an equalizer 78 that compensates for the frequency characteristics, a demodulator 79 that demodulates the equalizer output, a low-pass filter 80 that separates signal components from the demodulator output, a de-emphasis circuit 81, and a nonlinear de-emphasis circuit 82. The subtractor 76 is inserted between the low-pass filter 80 and the de-emphasis circuit 81. This configuration provides a benefit of reducing noise components leaking from the moire cancelling circuit 71 by the de-emphasis circuit 81 and the nonlinear de-emphasis circuit 82.

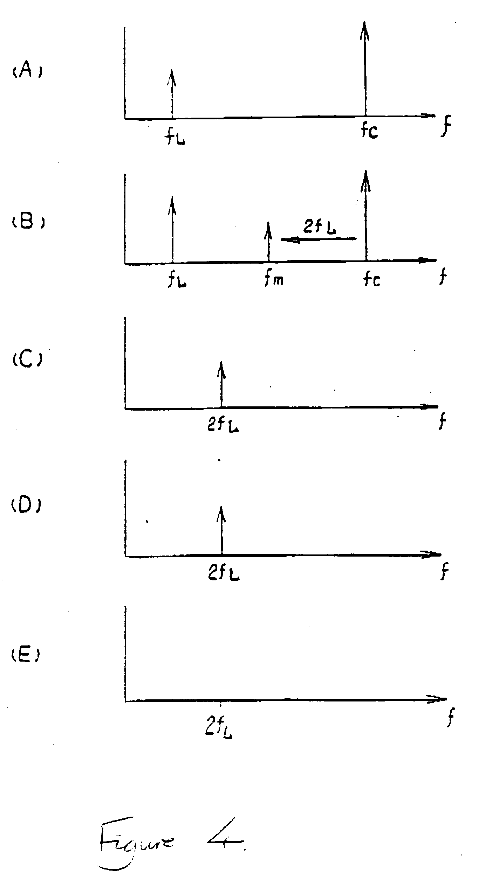

Fig. 4 shows a frequency spectrum diagram for explaining the operation of the Fig. 2 or Fig. 3 embodiments. The signal containing the carrier frequency f_{c} of the FM luminance signal and the down-converted chrominance signal frequency f_{L} as shown in Fig. 4 (A) are recorded. Passing such signal through the electromagnetic conversion system (i.e., the head and recording medium) causes fₘ = f_{c} - 2f_{L} to be generated as shown in Fig. 4 (B). Demodulating in the luminance signal reproducing system causes the fₘ component to be the cross modulation moire of 2f_{L} as shown in Fig. 4 (C). On the other hand, the 2f_{L} component is produced by the moire cancelling circuit as shown in Fig. 4 (D). Subtracting the spectrum of Fig. 4 (D) from that of Fig. 4 (C) cancels the moire as shown in Fig. 4 (E).

In the above embodiments, the frequency f_{L} component is the down-converted chrominance signal, but the present invention is not limited only to such signal. For example, signals obtained by line-sequentially frequency-modulated chrominance signals, such a R-Y, B-Y, or I and Q signals, or signals obtained by time-compressing and frequency-modulating chrominance difference signals may be used.

The double multiplier circuit 73 can be easily constructed by a known balanced demodulator and a filter that separates the doubled components. The phase adjuster 74 and gain adjuster 75 can be omitted.

## Claims

1. A frequency demodulation apparatus comprising frequency demodulating means (68-70) for demodulating a frequency modulated signal which has a carrier frequency f_{c} and contains a low-frequency signal having a frequency f_{L} and a cross-modulation signal component expressed as f_{c} - 2f_{L} to obtain a demodulated signal which contains a frequency component 2f_{L} as an undesired cross-modulation moire component:
characterized by further comprising:
moire component generating means (72-75) for extracting a low-frequency component f_{L} from said frequency-modulated signal and generating a 2f_{L} component as a moire component corresponding to said undesired cross-modulation moire component from the extracted low-frequency signal; and
subtracting means (76) for subtracting said moire component generated by said moire component generating means from said demodulated signal thereby to obtain a demodulated signal from which said undesired cross-modulation moire component is eliminated.

2. The apparatus according to claim 1, wherein said moire-component generating means comprises filter means (72) for extracting said low-freqency component from said frequency-modulated signal, and multiplying means (73) for multiplying the frequency f_{L} of the extracted low-frequency component by 2 thereby to obtain said 2f_{L} component.

3. The apparatus according to claim 1 or 2, wherein said moire component generating means includes means (74,75) for adjusting phase and gain of the generated moire component.

4. A signal recording and reproducing apparatus comprising:
means (62) for extracting a first signal from an input signal and for frequency-modulating a carrier frequency f_{c} with the first signal to obtain a frequency-modulated signal;
means (63) for extracting a second signal from the input signal and generating from the second signal a low-frequency signal having a frequency f_{L};
means (64) for adding the frequency-modulated signal and the low frequency signal to obtain a recording signal;
recording and reproducing means (66) for recording the recording signal on a recording medium and for reproducing the recorded signal from the recording medium to obtain a signal containing a reproduced low-frequency signal having the frequency f_{L} and a reproduced frequency-modulated signal which contains a cross-modulation component f_{c} - 2f_{L};
means (68) for extracting the reproduced frequency-modulated signal from the signal reproduced by the recording and reproducing means and the demodulating the extracted signal to obtain reproduced first signal which contains a component 2f_{L} as an undesired cross-modulation moire component;
means (69) for generating a reproduced second signal from the reproduced low-frequency signal; and
means (70) for adding the reproduced first and second signals to obtain a reproduced signal,
characterized by further comprising:
moire component generating means (72-75) for extracting a low-frequency component f_{L} from the signal reproduced by the recording and reproducing means (66) and for generating a moire component 2f_{L} corresponding to said undesired cross-modulation moire component; and
subtracting means (76) for subtracting said moire component generated by said moire component generating means from either said reproduced first signal or said reproduced signal thereby to obtain reproduced signal from which said undesired cross-modulation moire component is eliminated.

5. The apparatus according to claim 4, wherein said input signal is a video signal, and said first and second signals are a luminance signal and a chrominance signal, respectively.

6. The apparatus according to claim 4 or 5, wherein said moire component generating means comprises filter means (72) for extracting said low-frequency components from said reproduced frequency-modulated signal, and multiplying means (73) for multiplying the frequency f_{L} of the extracted low-frequency component by 2 thereby to obtain said 2f_{L} component.

7. The apparatus according to any of claims 4 to 6, wherein said moire component generating means includes means (74,75) for adjusting phase and gain of the generated moire component.

## Patentansprüche

1. Frequenzdemodulationsvorrichtung, die eine Frequenzdemodulationseinrichtung (68-70) umfaßt, die ein frequenzmoduliertes Signal demoduliert, das eine Trägerfrequenz f_{c} besitzt und ein Niederfrequenzsignal mit einer Frequenz f_{L} und einen als f_{c} - 2f_{L} ausgedrückten Kreuzmodulationssignalanteil enthält, um ein demoduliertes Signal zu erhalten, das einen Frequenzanteil 2f_{L} als einen unerwünschten Kreuzmodulation-Moire'-Anteil enthält:
gekennzeichnet durch weiter umfassend:
eine Moire'-Anteil-Erzeugungseinrichtung (72-75), die einen Niederfrequenzanteil f_{L} aus dem frequenzmodulierten Signal extrahiert und einen 2f_{L}-Anteil als Moire'-Anteil erzeugt, der dem unerwünschten Kreuzmodulation-Moire'-Anteil von dem extrahierten Niederfrequenzsignal entspricht, und
eine Subtraktionseinrichtung (76), die den von der Moire'-Anteil-Erzeugungseinrichtung erzeugten Moire'-Anteil von dem demodulierten Signal subtrahiert, um dadurch ein demoduliertes Signal zu erhalten, aus dem der unerwünschte Kreuzmodulation-Moire'-Anteil entfernt ist.

2. Vorrichtung nach Anspruch 1, worin die Moire'-Anteil-Erzeugungseinrichtung eine Filtereinrichtung (72) zum Extrahieren des Niederfrequenzanteils aus dem frequenzmodulierten Signal und eine Multiplikationseinrichtung (73) zum Multiplizieren der Frequenz f_{L} des extrahierten Niederfrequenzanteils mit 2 umfaßt, um dadurch den 2f_{L}-Anteil zu erhalten.

3. Vorrichtung nach Anspruch 1 oder 2, worin die Moire'-Anteil-Erzeugungseinrichtung eine Einrichtung (74,75) enthält, um die Phase und die Verstärkung des erzeugten Moire'-Anteils abzugleichen.

4. Signalaufnahme- und -wiedergabevorrichtung, umfassend:
eine Einrichtung (62), die ein erstes Signal aus einem Eingangssignal extrahiert und eine Trägerfrequenz f_{c} mit dem ersten Signal frequenzmoduliert, um ein frequenzmoduliertes Signal zu erhalten;
eine Einrichtung (63), die ein zweites Signal aus dem Eingangssignal extrahiert und aus dem zweiten Signal ein Niederfrequenzsignal mit einer Frequenz f_{L} erzeugt;
eine Einrichtung (64), die das frequenzmodulierte Signal und das Niederfrequenzsignal addiert, um ein Aufnahmesignal zu erhalten;
eine Aufnahme- und Wiedergabeeinrichtung (66), die das Aufnahmesignal auf einem Aufnahmemedium aufzeichnet und das aufgezeichnete Signal von dem Aufnahmemedium wiedergibt, um ein Signal zu erhalten, das ein wiedergegebenes Niederfrequenzsignal mit der Frequenz f_{L} und ein wiedergegebenes frequenzmoduliertes Signal enthält, das einen Kreuzmodulationsanteil f_{c} - 2f_{L} enthält;
eine Einrichtung (68), die das wiedergegebene frequenzmodulierte Signal aus dem von der Aufnahme- und Wiedergabeeinrichtung wiedergegebenen Signal extrahiert und das extrahierte Signal demoduliert, um ein wiedergegebenes erstes Signal zu erhalten, das einen Anteil 2f_{L} als unerwünschten Kreuzmodulation-Moire'-Anteil enthält;
eine Einrichtung (69), die ein wiedergegebenes zweites Signal aus dem wiedergegebenen Niederfrequenzsignal erzeugt, und
eine Einrichtung (70), die das wiedergegebene erste und zweite Signal addiert, um ein Wiedergabesignal zu erhalten,
gekennzeichnet durch weiter umfassend:
eine Moire'-Anteil-Erzeugungseinrichtung (72-75), die einen Niederfrequenzanteil f_{L} aus dem von der Aufnahme- und Wiedergabeeinrichtung (66) wiedergegebenen Signal extrahiert und einen Moire'-Anteil 2f_{L} erzeugt, der dem unerwünschten Kreuzmodulation-Moire'-Anteil entspricht, und
eine Subtraktionseinrichtung (76), die den von der Moire'-Anteil-Erzeugungseinrichtung erzeugten Moire'-Anteil von entweder dem wiedergegebenen ersten Signal oder dem Wiedergabesignal subtrahiert, um dadurch ein Wiedergabesignal zu erhalten, aus dem der unerwünschte Kreuzmodulation-Moire'-Anteil entfernt ist.

5. Vorrichtung nach Anspruch 4, worin das Eingangssignal ein Videosignal ist und das erste Signal ein Luminanzsignal und das zweite Signal ein Chrominanzsignal ist.

6. Vorrichtung nach Anspruch 4 oder 5, worin die Moire'-Anteil-Erzeugungseinrichtung eine Filtereinrichtung (72) zum Extrahieren der Niederfrequenzanteile aus dem wiedergegebenen frequenzmodulierten Signal und eine Multiplikationseinrichtung (73) zum Multiplizieren der Frequenz f_{L} des extrahierten Niederfrequenzanteils mit 2 umfaßt, um dadurch den 2f_{L}-Anteil zu erhalten.

7. Vorrichtung nach einem der Ansprüche 4 bis 6, worin die Moire'-Anteil-Erzeugungseinrichtung eine Einrichtung (74,75) enthält, um die Phase und die Verstärkung des erzeugten Moire'-Anteils abzugleichen.

## Revendications

1. Dispositif de démodulation de fréquence comprenant un moyen démodulateur de fréquence (68 à 70) pour démoduler un signal modulé en fréquence qui a une fréquence porteuse de f_{c} et qui contient un signal à basse fréquence ayant une fréquence de f_{L} et une composante de signal de transmodulation exprimée par f_{c} - 2f_{L}, pour obtenir un signal démodulé qui contient une composante de fréquence de 2f_{L} en tant que composante moirée de transmodulation, indésirable :
caractérisé en ce qu'il comprend en outre :
un moyen générateur de composante moirée (72 à 75) pour extraire une composante à basse fréquence de f_{L} dudit signal modulé en fréquence et pour produire une composante de 2f_{L} en tant que composante moirée correspondant à ladite composante moirée de transmodulation indésirable issue du signal à basse fréquence extrait ; et
un moyen de soustraction (76) pour soustraire, dudit signal démodulé, ladite composante moirée produite par ledit moyen générateur de composante moirée, pour obtenir ainsi un signal démodulé dont ladite composante moirée de transmodulation indésirable est éliminée.

2. Dispositif selon la revendication 1, dans lequel ledit moyen générateur de composante moirée comprend un moyen de filtrage (72) pour extraire ladite composante à basse fréquence dudit signal modulé en fréquence, et un moyen multiplicateur (73) pour multiplier par 2 la fréquence f_{L} de la composante à basse fréquence extraite, pour obtenir ainsi ladite composante de 2f_{L}.

3. Dispositif selon la revendication 1 ou 2, dans lequel ledit moyen générateur de composante moirée comprend un moyen (74, 75) pour ajuster la phase et le gain de la composante moirée produite.

4. Appareil d'enregistrement et de reproduction de signaux comprenant :
un moyen (62) pour extraire un premier signal d'un signal d'entrée et pour moduler en fréquence, avec le premier signal, une fréquence porteuse de f_{c} pour obtenir un signal modulé en fréquence ;
un moyen (63) pour extraire un second signal du signal d'entrée et pour produire, à partir du second signal, un signal à basse fréquence ayant une fréquence de f_{L} ;
un moyen (64) pour additionner le signal modulé en fréquence et le signal à basse fréquence pour obtenir un signal d'enregistrement ;
un moyen d'enregistrement et de reproduction (66) pour enregistrer le signal d'enregistrement sur un support d'enregistrement et pour reproduire, à partir du support d'enregistrement, le signal enregistré, pour obtenir un signal contenant un signal à basse fréquence reproduit ayant une fréquence de f_{L} et un signal modulé en fréquence reproduit qui contient une composante de transmodulation de f_{c} - 2f_{L} ;
un moyen (68) pour extraire le signal modulé en fréquence reproduit du signal reproduit par le moyen d'enregistrement et de reproduction et pour démoduler le signal extrait, pour reproduire le premier signal reproduit qui contient une composante de 2f_{L} et une composante moirée de transmodulation indésirable ;
un moyen (69) pour produire un second signal reproduit à partir du signal à basse fréquence reproduit ; et
un moyen (70) pour additionner les premier et second signaux reproduits pour obtenir un signal reproduit ;
caractérisé en ce qu'il comprend en outre :
un moyen générateur de composante moirée (72 à 75) pour extraire une composante à basse fréquence de f_{L} du signal reproduit par le moyen d'enregistrement et de reproduction (66) et pour produire une composante moirée de 2f_{L} correspondant à ladite composante moirée de transmodulation indésirable ; et
un moyen de soustraction (76) pour soustraire, soit dudit premier signal reproduit soit dudit signal reproduit, ladite composante moirée produite par ledit moyen générateur de composante moirée, pour obtenir ainsi un signal démodulé dont ladite composante moirée de transmodulation indésirable est éliminée.

5. Appareil selon la revendication 4, dans lequel ledit signal d'entrée est un signal vidéo, et lesdits premier et second signaux sont, respectivement un signal de luminance et un signal de chrominance.

6. Appareil selon la revendication 4 ou 5, dans lequel ledit moyen générateur de composante moirée comprend un moyen de filtrage (72) pour extraire lesdites composantes à basse fréquence dudit signal modulé en fréquence reproduit, et un moyen multiplicateur (73) pour multiplier par 2 la fréquence f_{L} de la composante à basse fréquence extraite, pour obtenir ainsi ladite composante de 2f_{L}.

7. Appareil selon l'une quelconque des revendications 4 à 6, ledit moyen générateur de composante moirée comprend un moyen (74, 75) pour ajuster la phase et le gain de la composante moirée produite.
